# EUROPÄISCHE PATENTSCHRIFT

(11) **EP 4 330 694 B1**
(45) Veröffentlichungstag und Bekanntmachung des Hinweises auf die Patenterteilung: **05.03.2025**
(21) Anmeldenummer: 22725876.1
(22) Anmeldetag: 27.04.2022
(51) Int. Cl.: G01R 31/327

(54) **VORRICHTUNG UND VERFAHREN ZUM ERKENNEN EINER ABNUTZUNG EINER ELEKTROMECHANISCHEN EINRICHTUNG**
DEVICE AND METHOD FOR DETECTING WEAR IN AN ELECTROMECHANICAL APPARATUS
DISPOSITIF ET PROCÉDÉ PERMETTANT DE DÉTECTER DE L'USURE DANS UN APPAREIL ÉLECTROMÉCANIQUE

(30) Priorität: 30.04.2021 BE 202105335
(43) Veröffentlichungstag der Anmeldung: 06.03.2024
(73) Patentinhaber: Phoenix Contact GmbH & Co. KG, 32825 Blomberg (DE)
(72) Erfinder: SCHAPER, Elmar, 32676 Lügde (DE); SCHOLZ, Peter, 33034 Brakel (DE); WINKEL, Fabian, 33098 Paderborn (DE)
(74) Vertreter: Maiwald GmbH
(86) Internationale Anmeldenummer: PCT/EP2022/061237
(87) Internationale Veröffentlichungsnummer: WO 2022/229274

(56) Entgegenhaltungen:
- EP-A1- 3 745 229
- WO-A1-2020/115313
- CN-A- 111 310 314
- DE-A1- 102018 221 270
- US-A1- 2019 272 479
- US-A1- 2021 117 787

## Beschreibung

### Technisches Gebiet

Die vorliegende Erfindung betrifft Systeme für die Überwachung eines Abnutzungsverhaltens.

Insbesondere betrifft die vorliegende Erfindung eine Vorrichtung und ein Verfahren zum Erkennen einer Abnutzung einer elektromechanischen Einrichtung.

### Technischer Hintergrund

Im Zuge der vorausschauenden Wartung ist es wichtig, den Zustand von elektromechanischen Schaltelementen wie elektromechanischen Relais oder Schützen oder elektromechanische Ventile - im Besonderen auch Hydraulik- und oder Pneumatik Aktoren - zu kennen und das gebrauchte oder verschlissene Aktor bzw. Schaltelement schon vor einem möglichen Ausfall auszutauschen um Stillstand oder Ausfallzeiten zu vermeiden.

In sicherheitsrelevanten Anwendungen beispielsweise nach den Normen IEC61508 oder ISO13849 kann eine kontinuierliche Zustandsüberwachung von Aktoren bzw. schaltenden Elementen noch deutlich wichtiger sein.

Die DE 10 2010 041 998 A1 beschreibt ein Verfahren zur Vorhersage der Einsatzfähigkeit eines Relais oder eines Schützes. Ein durch das Relais oder das Schütz fließender Strom und/oder eine an dem Relais oder dem Schütz anliegende Spannung wird wiederholt gemessen, und die Messwerte werden an eine Beobachtungseinheit übermittelt. Die Beobachtungseinheit macht auf Grundlage der Messwerte und eines Modells eine Vorhersage über die Einsatzfähigkeit.

Die DE 10 2018 114 425 A1 und die DE 10 2010 041 998 A1 beschreiben Systeme, die eine Überwachung der Kontaktseite eines elektromechanischen Relais ermöglichen. Folglich kann mit diesen Systemen lediglich ein fehlerhaftes Verhalten detektiert werden.

Im Rahmen der DE 10 2013 219 243 B4 erfolgt eine Abschätzung der Alterung der Kontakte eines Relais über einen stromabhängigen Zähler. Die Lebensdauer von Relais hängt maßgeblich von der Impedanz der zu schaltenden Last, der anliegenden Spannung und dem Strom ab**.** Da mit dem Ansatz nur einer der Faktoren betrachtet werden kann, erscheint erfolgreiche Abschätzung der Alterung nur begrenzt möglich.

Die US 10,895,608 B2 beschreibt eine Vorrichtung und ein Verfahren zum Erfassen der Bewegung eines Tauchankers des Elektromagneten umfasst das Erfassen einer Spitze in einem an eine Spule des Elektromagneten angelegten Stromsignal. Ein vorbestimmter Schwellenwert wird zu dem an die Spule des Elektromagneten angelegten Stromsignal addiert, um ein pegelverschobenes Signal zu erzeugen. Das pegelverschobene Signal und das Spitzensignal werden verglichen, um die Bewegung eines Stößels des Magneten zu erkennen.

Die DE 10 2018 221 270 A1 beschreibt eine Vorrichtung zur Verschleißerkennung einer elektromechanischen Schalteinrichtung anhand eines maschinellen Tiefenlernen-Verfahrens.

Die US 2021/0117787 A1 beschreibt Verfahren zum Fusionieren von Sensordaten verschiedener Modalitäten.

### Zusammenfassung der Erfindung

Es ist eine Aufgabe der vorliegenden Erfindung, eine verbesserte Vorrichtung und ein verbessertes Verfahren zur Erkennung einer Abnutzung eines elektromechanischen Bauteils breitzustellen.

Diese Aufgabe wird durch die Gegenstände der unabhängigen Patentansprüche gelöst. Weiterbildungen und Ausführungsformen sind den abhängigen Patentansprüchen, der Beschreibung und den Figuren der Zeichnungen zu entnehmen.

Der Begriff der "Abnutzung" des elektromechanischen Bauteils kann dabei eine Anomalie des elektromechanischen Bauteils oder auch einen normalen oder kontinuierlichen Verschleiß umfassen. Der Begriff der "Abnutzung" des elektromechanischen Bauteils kann dabei auch eine Alterung umfassen. Der Begriff der "Abnutzung" kann dabei auch einen unmittelbar bevorstehenden Spontanausfall beinhalten.

Ein erster Aspekt der vorliegenden Erfindung betrifft eine Vorrichtung zum Erkennen einer Abnutzung einer elektromechanischen Einrichtung, wobei die Vorrichtung umfasst: eine Messeinrichtung, welche dazu ausgebildet ist, mindestens einen vorbestimmten Betriebsparameter der elektromechanischen Einrichtung zu erfassen; und eine Auswerteeinrichtung, welche dazu ausgebildet ist, anhand von maschinellen Lernen unter Zuhilfenahme von Massendaten, vorzugsweise in Form von Trainingsdaten, aus dem erfassten vorbestimmten Betriebsparameter der elektromechanischen Einrichtung einen aktuellen Betriebszustand der elektromechanischen Einrichtung zu ermitteln.

Die vorliegende Erfindung ermöglicht, den Zustand von elektromechanischen Aktoren, zu bestimmen und das gebrauchte oder verschlissene Aktoren schon vor einem drohenden, möglichen Ausfall auszutauschen, um eine Stillstandzeit zu minieren oder das Auftreten eines Stillstands zu verhindern oder sonstige Störungen zu vermeiden.

Mit der vorliegenden Erfindung soll die prädiktive Instandhaltung von elektromechanischen Aktoren unter der Zuhilfenahme von maschinellen Lernverfahren ermöglicht werden. Elektromechanische Aktoren finden z.B. in der Form von Relais oder Ventilen Verwendung als Bindeglied zwischen Steuerungs- und Prozessebene und sind daher von kritischer Bedeutung für den Betrieb einer Anlage.

Die vorliegende Erfindung ermöglicht, dass eine Alterung von einer elektromechanischen Aktoren mit minimalem Messaufwand zuverlässig bestimmt wird.

Die vorliegende Erfindung ermöglicht durch Methoden der künstlichen Intelligenz, wie maschinelles Lernen oder wie Künstliche neuronale Netze, auch künstliche neuronale Netzwerke, basierend auf in einem Anlernprozess verwendeten Trainingsdaten Prädiktionen und/oder Schätzungen zu aktuellen Messdaten zu treffen.

Mit auf Englisch sogenannten "Deep Learning"-Methoden, auf Deutsch etwa "tiefgehendes Lernen", nachfolgend auch als maschinelles Tiefenlernen-Verfahren" bezeichnet, wird beispielsweise eine Klasse von Optimierungsmethoden künstlicher neuronaler Netze definiert, die zahlreiche Zwischenlagen - englisch "hidden layers" - zwischen Eingabeschicht und Ausgabeschicht haben und dadurch eine umfangreiche innere Struktur aufweisen.

Dies ermöglicht vorteilhaft, dass keine manuelle Merkmalsextraktion bzw. Festlegung von überwachten Merkmalen benötigt wird. Daher können präzise Vorhersagen getroffen werden, wenn die Modelle mit Massendaten, auf Englisch auch "Big Data", in der Form von Trainingsdaten trainiert werden, wobei hier auch eine Markierung der Trainingsdaten mit Zustandsdaten der elektromechanischen Schalteinrichtungen erfolgen kann, d.h. referenziert oder gelabelt.

Die vorliegende Erfindung beschreibt eine Vorrichtung zur Überwachung von elektromechanischen Aktoren, wobei die Vorrichtung eine Messeinrichtung und eine Auswerteeinrichtung umfasst, mit denen unter Zuhilfenahme von maschinellen Lernverfahren Rückschlüsse auf den Zustand des elektromechanischen Aktors gezogen werden.

Mit dieser Vorrichtung soll die prädiktive Instandhaltung von elektromechanischen Aktuatoren ermöglicht werden, um zum einen die Instandhaltung langfristig zu planen und zum anderen kurzfristig auf Zustandsänderungen reagieren zu können. Auf diesem Weg kann möglichen Ausfällen der Aktoren durch Wartung vorgebeugt werden und bspw. die Anlagenverfügbarkeit erhöht werden.

Für den Betreiber einer Anlage ergeben sich somit sowohl ein ökonomischer als auch ein ökologischer Nutzen. Letzterer kann durch das Vermeiden von Fehlproduktionen und die maximale Ausnutzung der Aktoren erzeugt werden. Darüber hinaus kann durch eine kontinuierliche Überwachung der Aktoren die Sicherheit von Systemen gesteigert werden.

In dem neuronalen Netz wird jedoch kein direkter Vergleich von den Schaltzyklen miteinander durchgeführt, sondern durch Optimierungsverfahren im Trainingsprozess hat das Verfahren selber gelernt bzw. die internen Parameter so optimiert, dass relevante Merkmale, die für den Verschleiß charakteristisch sind, implizit im neuronalen Netz enthalten sind und somit Prognosen zu aktuellen unbekannten Eingangsdaten ausgegeben werden können.

Das in der Auswerteeinrichtung implementierte neuronale Netz ist in einer Ausführungsform der vorliegenden Erfindung zuvor trainiert worden und ist durch die Auswertung von aktuellen Messungen in der Lage, auf den aktuellen Zustand des aktuell verbauten Aktors, beispielsweise ein Relais, zu schließen, den Verschleißzustand zu ermitteln.

Vorteilhafte Ausgestaltungen der vorliegenden Erfindung sind den Unteransprüchen zu entnehmen.

In einer vorteilhaften Ausführungsform der vorliegenden Erfindung ist vorgesehen, dass die Auswerteeinrichtung dazu ausgebildet ist, für das maschinelle Lernen einen Schätzer mit Betriebsdaten zu verschiedenen Abnutzungsgraden zu trainieren und den trainierten Schätzer für das Ermitteln des aktuellen Betriebszustands der elektromechanischen Einrichtung zu verwenden.

In einer vorteilhaften Ausführungsform der vorliegenden Erfindung ist vorgesehen, dass der Schätzer als ein Klassifizierungs- und/oder Regressionsschätzer ausgebildet ist.

In einer vorteilhaften Ausführungsform der vorliegenden Erfindung ist vorgesehen, dass der Schätzer ein tiefes, neuronales Netz aufweist, das Faltungsschichten und rekurrente Schichten aufweist.

In einer vorteilhaften Ausführungsform der vorliegenden Erfindung ist vorgesehen, dass die Auswerteeinrichtung dazu ausgebildet ist, den aktuellen Betriebszustand aus dem erfassten vorbestimmten Betriebsparameter unter Annahme einer multimodalen Ausfallverteilung zu ermitteln, wobei vorzugsweise die Auswerteeinrichtung dazu ausgebildet ist, den aktuellen Betriebszustand aus dem erfassten vorbestimmten Betriebsparameter über eine Mehrzahl von Zielgrößen zu ermitteln, wobei besonders bevorzugt die Mehrzahl von Zielgrößen einer multimodalen Ausfallverteilung entsprechen.

In einer vorteilhaften Ausführungsform der vorliegenden Erfindung ist vorgesehen, dass die Auswerteeinrichtung dazu ausgebildet ist, für das maschinelle Lernen einen Klassifizierungs- und Regressionsschätzer mit run-to-failure Daten zu trainieren und der Klassifizierungs- und Regressionsschätzer für das Ermitteln des aktuellen Betriebszustands der elektromechanischen Einrichtung zu verwenden.

In einer vorteilhaften Ausführungsform der vorliegenden Erfindung ist vorgesehen, dass der Klassifizierungs- und Regressionsschätzer ein tiefes neuronales Netz aufweist, das Faltungsschichten und rekurrente Schichten aufweist.

In einer vorteilhaften Ausführungsform der vorliegenden Erfindung ist vorgesehen, dass die Messeinrichtung ferner dazu ausgebildet ist, zum dem erfassten mindestens einen vorbestimmten Betriebsparameter der elektromechanischen Einrichtung weitere Informationen in der Form eines Zeitstempels oder eines Zählerstands hinzuzufügen.

In einer vorteilhaften Ausführungsform der vorliegenden Erfindung ist vorgesehen, dass die Messeinrichtung ferner dazu ausgebildet ist, den Betriebsparameter der elektromechanischen Einrichtung kontinuierlich zu erfassen oder nur bei einem Schaltereignis der elektromechanischen Einrichtung den Betriebsparameter zu erfassen.

In einer vorteilhaften Ausführungsform der vorliegenden Erfindung ist vorgesehen, dass die Auswerteeinrichtung dazu ausgebildet ist, ferner Prädiktionen über einen zukünftigen Betriebszustand der elektromechanischen Einrichtung zu ermitteln.

In einer vorteilhaften Ausführungsform der vorliegenden Erfindung ist vorgesehen, dass die Auswerteeinrichtung dazu ausgebildet ist, den aktuellen Betriebszustand oder die Prädiktionen über den zukünftigen Betriebszustand der elektromechanischen Einrichtung nach Ablauf einer Zeitspanne oder durch ein Trigger-Ereignis getriggert zu ermitteln.

In einer vorteilhaften Ausführungsform der vorliegenden Erfindung ist vorgesehen, dass als Prädiktionen vorgesehen sind:
- eine restliche nutzbare Lebensdauer als relativer Anteil an der gesamten Lebensdauer der elektromechanischen Einrichtung;
- eine restliche nutzbare Lebensdauer als absoluter Anteil an Nutzungszyklen oder -zeit der elektromechanischen Einrichtung;
- eine Risikowahrscheinlichkeit für einen spontanen Ausfall der elektromechanischen Einrichtung;
- eine Typisierung der elektromechanischen Einrichtung;
- ein Koeffizient für eine Belastung oder eine Klassifizierung einer Last der elektromechanischen Einrichtung;
- eine binär-codierte Fehlermeldung;
- eine binär-codierte Betriebsbereitschaft; und/oder
- prozessbezogene Informationen der elektromechanischen Einrichtung.

In einer vorteilhaften Ausführungsform der vorliegenden Erfindung ist vorgesehen, dass die Auswerteeinrichtung dazu ausgebildet ist, in eine Fassungsvorrichtung für die elektromechanische Einrichtung integriert zu werden.

In einer vorteilhaften Ausführungsform der vorliegenden Erfindung ist vorgesehen, dass die Vorrichtung ferner eine Anzeigeneinrichtung umfasst, welche vorzugsweise dazu ausgebildet ist, den aktuellen Betriebszustand der elektromechanischen Einrichtung anzuzeigen.

In einer vorteilhaften Ausführungsform der vorliegenden Erfindung ist vorgesehen, dass der mindestens eine vorbestimmte Betriebsparameter der elektromechanischen Einrichtung eine Betätigungskraft, oder ein Druckschlag eines Fluid, womit ein anderer Bewegungsvorgang des Ankers ausgelöst wird, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung umfasst; und/oder wobei die Massendaten beliebige Betriebsparameter umfassen und die beliebigen Betriebsparameter eine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung der elektromechanischen Einrichtung umfassen.

In einer vorteilhaften Ausführungsform der vorliegenden Erfindung ist vorgesehen, dass die Messeinrichtung dazu ausgebildet ist, die beliebigen Betriebsparameter als Kennlinien basierend auf einer Vorabmessung während einer Initialisierungsphase der elektromechanischen Einrichtung zu erfassen.

In einem zweiten Aspekt der vorliegenden Erfindung ist ein Verfahren zum Erkennen einer Abnutzung einer elektromechanischen Einrichtung vorgesehen, wobei das Verfahren folgende Verfahrensschritte umfasst:
Als ein erster Verfahrensschritt erfolgt ein Erfassen von mindestens einem vorbestimmten Betriebsparameter der elektromechanischen Einrichtung mittels einer Messeinrichtung.

Als ein zweiter Verfahrensschritt erfolgt ein Ermitteln eines aktuellen Betriebszustandes der elektromechanischen Einrichtung anhand eines maschinellen Tiefenlernen-Verfahrens unter Zuhilfenahme von Massendaten, vorzugsweise in Form von Trainingsdaten, aus dem erfassten vorbestimmten Betriebsparameter der elektromechanischen Schalteinrichtung mittels einer Auswerteeinrichtung.

Nach einem dritten Aspekt umfasst die vorliegende Erfindung ein Computerprogramm oder ein Computerprogrammprodukt, umfassend Befehle, die bei der Ausführung des Programms durch einen Computer diesen veranlassen, dass die Schritte des Verfahrens nach dem zweiten Aspekt oder einer beliebigen Ausführungsform des zweiten Aspektes ausgeführt werden.

Nach einem vierten Aspekt umfasst die vorliegende Erfindung ein computerlesbares Speichermedium, umfassend Befehle, die bei der Ausführung durch einen Computer diesen veranlassen, die Schritte des Verfahrens nach dem zweiten Aspekt oder einer beliebigen Ausführungsform des zweiten Aspektes ausgeführt werden.

Die beschriebenen Ausgestaltungen und Weiterbildungen lassen sich beliebig miteinander kombinieren.

Weitere mögliche Ausgestaltungen, Weiterbildungen und Implementierungen der vorliegenden Erfindung umfassen auch nicht explizit genannte Kombinationen von zuvor oder im Folgenden bezüglich der Ausführungsformen beschriebenen Merkmale der vorliegenden Erfindung.

Die beiliegenden Zeichnungen sollen ein weiteres Verständnis der Ausführungsformen der vorliegenden Erfindung vermitteln.

Die beiliegenden Zeichnungen veranschaulichen Ausführungsformen und dienen im Zusammenhang mit der Beschreibung der Erklärung von Konzepten der vorliegenden Erfindung.

Andere Ausführungsformen und viele der genannten Vorteile ergeben sich im Hinblick auf die Figuren der Zeichnungen. Die dargestellten Elemente der Figuren der Zeichnungen sind nicht notwendigerweise maßstabsgetreu zueinander gezeigt.

### Kurze Beschreibung der Figuren

Es zeigen:
- Fig. 1:: eine schematische Darstellung eines Messaufbaus des erfindungsgemäßen Verfahrens skizziert gemäß einem Ausführungsbeispiel der vorliegenden Erfindung; und
- Fig. 2:: eine schematische Darstellung eines Spulenstroms für einen Ein- bzw. Ausschaltvorgang eines elektromechanischen Relais gemäß einem Ausführungsbeispiel der vorliegenden Erfindung;
- Fig. 3:: eine schematische Darstellung eines Spulenstroms eines Relais im Ausschaltvorgang exemplarisch über die gesamte Lebensdauer gemäß einem Ausführungsbeispiel der vorliegenden Erfindung;
- Fig. 4:: eine schematische Darstellung eines Spulenstroms eines Relais im Ausschaltvorgang exemplarisch über die gesamte Lebensdauer gemäß einem Ausführungsbeispiel der vorliegenden Erfindung;
- Fig. 5:: eine schematische Darstellung eines Diagramms, das die Prädiktionen für ein Relais über seine gesamte Lebensdauer gemäß einem Ausführungsbeispiel der vorliegenden Erfindung enthält;
- Fig. 6:: eine schematische Darstellung eines Diagramms, das die Prädiktionen für ein Relais über seine gesamte Lebensdauer gemäß einem Ausführungsbeispiel der vorliegenden Erfindung enthält;
- Fig. 7:: eine schematische Darstellung einer Vorrichtung gemäß einem Ausführungsbeispiel der vorliegenden Erfindung;
- Fig. 8:: eine schematische Darstellung eines Stand-Alone-Relais-Sockel gemäß einem Ausführungsbeispiel der vorliegenden Erfindung;
- Fig. 9:: eine schematische Darstellung einer Abwandlung von dem Relais-Sockel aus Figur 8 gemäß einem Ausführungsbeispiel der vorliegenden Erfindung;
- Fig. 10:: eine schematische Darstellung einer Anordnung, bei der mehrere Relaissockel über einen lokalen Kommunikationsbus miteinander verbunden sind, gemäß einem Ausführungsbeispiel der vorliegenden Erfindung; und
- Fig. 11:: zeigt die Funktionsweise der Auswertungsvorrichtung gemäß einem Ausführungsbeispiel der vorliegenden Erfindung;
- Fig. 12:: eine schematische Darstellung einer Vorrichtung zum Erkennen einer Abnutzung einer elektromechanischen Einrichtung gemäß einem Ausführungsbeispiel der vorliegenden Erfindung;
- Fig. 13:: eine schematische Darstellung eines Flussdiagramms eines Verfahrens zum Erkennen einer Abnutzung einer elektromechanischen Einrichtung gemäß einem Ausführungsbeispiel der vorliegenden Erfindung; und
- **Fig. 14:**: eine schematische Darstellung einer Fehlerverteilung oder Ausfallverteilung einer Abnutzung einer elektromechanischen Einrichtung gemäß einem Ausführungsbeispiel der vorliegenden Erfindung.

### Detaillierte Beschreibung der Ausführungsbeispiele

In den Figuren der Zeichnungen bezeichnen gleiche Bezugszeichen gleiche oder funktionsgleiche Elemente, Bauteile, Komponenten oder Verfahrensschritte, soweit nichts Gegenteiliges angegeben ist.

Der Begriff "Künstliches neuronales Netz" wie von der vorliegenden Erfindung verwendet umfasst beispielsweise ein Rechnernetz basierend auf einer Sammlung von miteinander verbundenen Einheiten oder Knoten, die als künstliche Neuronen bezeichnet werden und die Neuronen in einem biologischen Gehirn modellieren.

Der Begriff "rekurrentes neuronales Netz" wie von der vorliegenden Erfindung verwendet umfasst beispielsweise ein neuronales Netz, das sich im Gegensatz zu einem normalen, auch als Feedforward-Netz bezeichneten Netz, durch Verbindungen von Neuronen einer Schicht zu Neuronen derselben oder einer vorangegangenen Schicht auszeichnet, wobei Verbindungen zwischen Knoten einen gerichteten Graphen entlang einer zeitlichen Abfolge bilden.

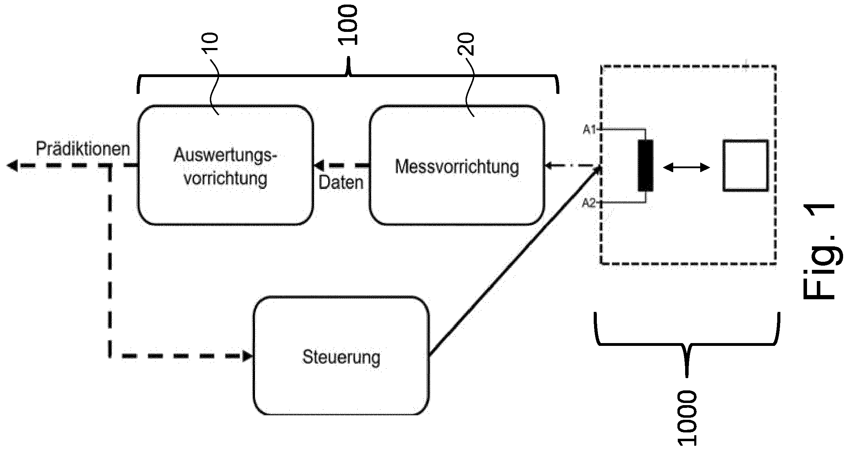

Die Figur 1 zeigt eine schematische Darstellung eines Messaufbaus des erfindungsgemäßen Verfahrens skizziert gemäß einem Ausführungsbeispiel der vorliegenden Erfindung.

In Figur 1 ist der Messaufbau des erfindungsgemäßen Verfahrens skizziert. Ein elektromechanischer Aktor beinhaltet eine Spule, an die über die Kontakte A1 und A2 eine Spannung angelegt werden kann. Sobald eine Spannung an der Spule anliegt, beginnt ein Strom durch die Spule zu fließen und ein Magnetfeld wird aufgebaut.

Durch dieses Magnetfeld wird eine Kraft auf ein weiteres Bauteil ausgeübt, womit, je nach Aktor und Anwendung, ein definierter Zustand herbeigeführt wird.

Die vorliegende Erfindung weist den Vorteil auf, dass aus den Zustandsgrößen der Spule auf den Zustand des elektromechanischen Aktors geschlossen werden kann, erläutert wird dies anhand des Beispiels eines elektromechanischen Relais. Dazu werden Zustandsgrößen der Spule, wie Spulenstrom und Spulenspannung, über die gesamte Lebensdauer von elektromechanischen Relais erfasst.

Die vorliegende Erfindung weist den Vorteil auf, dass auch nur am Aktor gemessen werden kann, also z.B. nur die Kontaktspannung und/oder den Kontaktstrom.

Daneben können auch andere Kenngrößen wie z.B. die Bestimmung des Schaltzeitpunktes über andere elektrische Schaltungen gemessen werden.

Hier kann eine entsprechende Messschaltung verwendet werden, bei der mit einer speziellen Schaltungstechnik jederzeit ermittelt werden kann, welchen Schaltzustand die Kontakte eines Relais aufweisen.

Die Annahme ist, dass die Messungen der Messgrößen Informationen enthalten, die auf den Verschleiß des Relais schließen lassen. Die Messgrößen werden von einer oder mehreren Messvorrichtungen digital erfasst, weitere Informationen wie z.B. Zeitstempel oder Zählerstände können zusätzlich hinzugefügt werden.

Die Daten können kontinuierlich vorliegen oder nur bei Schaltereignissen aktualisiert werden. So kann die Kontaktspannung nur dann übermittelt werden, wenn auch ein Schaltereignis vorliegt.

Die aktualisierten Daten werden genutzt, um mit mindestens einem maschinellen Lernverfahren Prädiktionen über den Zustand des elektromechanischen Aktors zu treffen.

Die Verarbeitung der Daten kann sowohl nach dem Überschreiten einer Zeitschranke als auch durch Events, wie bspw. das Anlegen einer Spannung, ausgelöst werden.

Mögliche Prädiktionen der maschinellen Lernverfahren sind:
- Restliche nutzbare Lebensdauer als relativer Anteil an der gesamten Lebensdauer
- Restliche nutzbare Lebensdauer als absolute Anzahl an Nutzungszyklen oder -zeit
- Risiko für einen spontanen Ausfall in Prozent
- Typisierung des elektromechanischen Aktors
- Koeffizient für die Belastung oder Klassifizierung der Last des Aktors (Speziell Feedback bei Überlastung vom Aktor, Gründe können sowohl Systemdesignfehler als auch Defekte anderer Systemkomponenten sein)
- Binäre Fehlermeldung
- Binäre Betriebsbereitschaft
- Prozessbezogene Informationen, wie beispielsweise eine Temperatur des Aktors

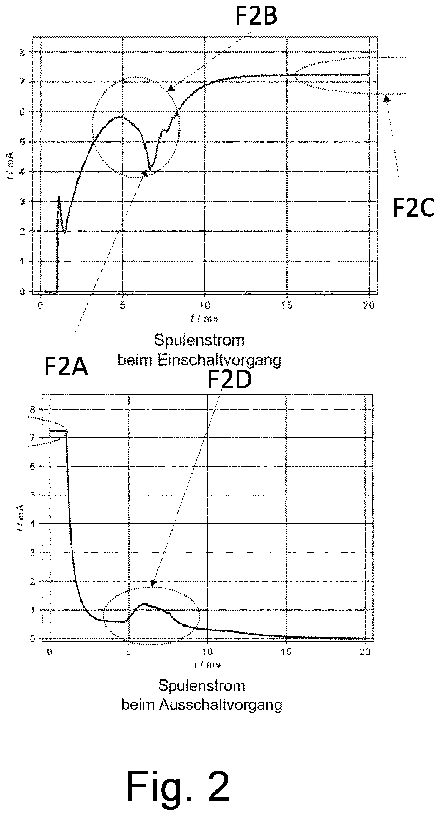

Die Figur 2 zeigt eine schematische Darstellung eines Spulenstroms für einen Ein- bzw. Ausschaltvorgang eines elektromechanischen Relais gemäß einem Ausführungsbeispiel der vorliegenden Erfindung.

In Figur 2 ist der Spulenstrom für einen Ein- bzw. Ausschaltvorgang eines elektromechanischen Relais beispielhaft dargestellt. In den folgenden Figuren wird diese Zustandsgröße exemplarisch für elektromechanische Relais analysiert.

Beim Einschalten ist auszumachen, dass der Strom sich gemäß einer realen Spule verhält und steigt dementsprechend von 1 ms bis etwa 4 ms an. Ab etwa 5 ms nimmt der Strom ab, das ist damit zu begründen, dass ein magnetischer Anker durch das Magnetfeld der Spule bewegt wird und damit wiederrum die Remanenz des magnetischen Kreises verändert. Letzteres führt zur beobachtbaren Verringerung des Stromes.

Nach wenigen Millisekunden erreicht der Anker seine Endposition, womit die Remanenz nicht mehr geändert wird und der Strom wieder gemäß einer realen Spule ansteigen kann. Das Erreichen der Endposition ist als lokales Minimum auszumachen.

Folglich enthält der Spulenstrom beim Einschalten eine Vielzahl von Informationen über den elektromechanischen Aktor u.a. die Bewegungsgeschwindigkeit, Bewegungszeitraum, Temperatur, Ankeraufschlag und 'Gegenkräfte' nach dem Aufschlag.

Für das Ausschalten ist zu erkennen, dass der Strom zunächst gemäß einer realen Spule abfällt. Ab etwa 3 ms ist jedoch ein Anstieg im Strom zu beobachten, hier wird durch die Rückbewegung des Ankers in die Ruheposition ein Strom induziert. Nach dem lokalen Maximum fällt der Strom wieder gemäß einer realen Spule ab. Somit enthält der Spulenstrom auch im Abschalten eine Vielzahl von relevanten Informationen über den elektromechanischen Aktor.

Schlussendlich wird mit dieser Betrachtung aufgezeigt, dass der Spulenstrom, der nur eine Zustandsgröße darstellt, viele Informationen enthält, die für den Zustand eines Relais relevant sind.

Diese Informationen sollen mit der vorliegenden Erfindung als Black Box Modellierung mittels maschinellen Lernverfahren zur Prädiktion des Zustandes der elektromechanischen Aktoren herangezogen werden.

Im Bereich F2A in der Figur 2 ist ein Ankeraufschlag der elektromechanischen Einrichtung 1000 dargestellt.

Im Bereich F2B in der Figur 2 ist dargestellt, dass durch das Magnetfeld der Spule im Aktor ein Anker bewegt wird, der wiederrum die Remanenz der Spule und damit den Stromfluss ändert (Einbruch des Stromes).

Im Bereich F2C in der Figur 2 ist dargestellt:
Bei konstanter Spannung kann mit dem Spulenstrom auf die Spulentemperatur und damit auf die Aktortemperatur geschlossen werden.

Im Bereich F2D in der Figur 2 ist folgendes dargestellt.

Der Anker wird nach Abschalten der Versorgungsspannung in seine Ruheposition bewegt dabei wird ein Strom in der Spule induziert

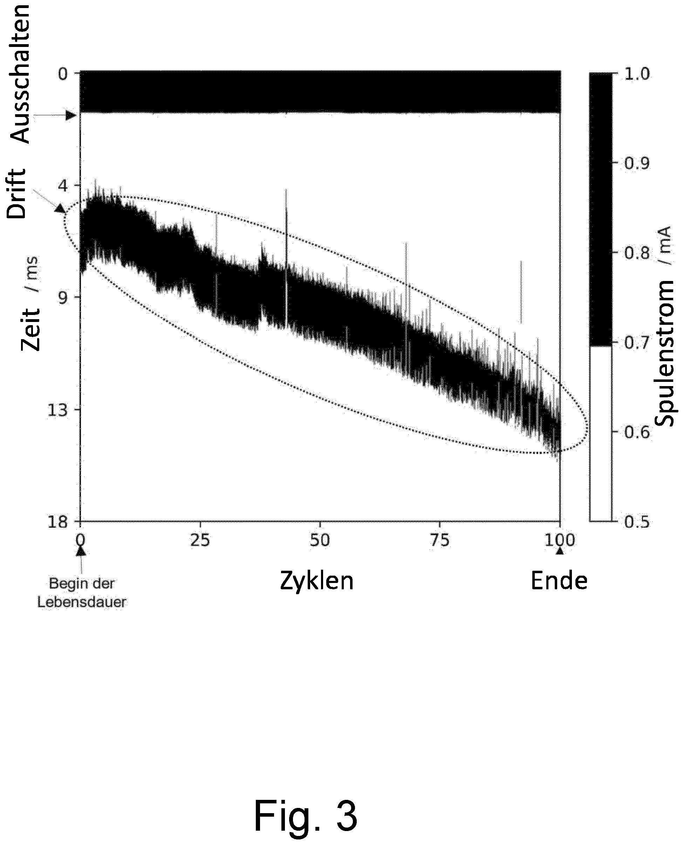

Die Figur 3 zeigt eine schematische Darstellung eines Spulenstroms eines Relais im Ausschaltvorgang exemplarisch über die gesamte Lebensdauer gemäß einem Ausführungsbeispiel der vorliegenden Erfindung.

In Figur 3 ist der Spulenstrom eines Relais im Ausschaltvorgang exemplarisch über die Gesamte Lebensdauer dargestellt. Das Relais wurde unter realistischen Bedingungen in einem vollautomatischen Messaufbau mit einer genormten induktiven Last (DC13) gealtert. Es ist stellvertretend für die Relais, die eine kontinuierliche Degeneration aufweisen, wie sie bereits in anderen Patenten beschrieben wurde. Konkret ist zu erkennen, dass der induzierte Strom mit zunehmender Lebensdauer später und geringer auftritt. Über diese Information wäre dementsprechend eine Schätzung der Restlebensdauer eines elektromechanischen Aktors möglich.

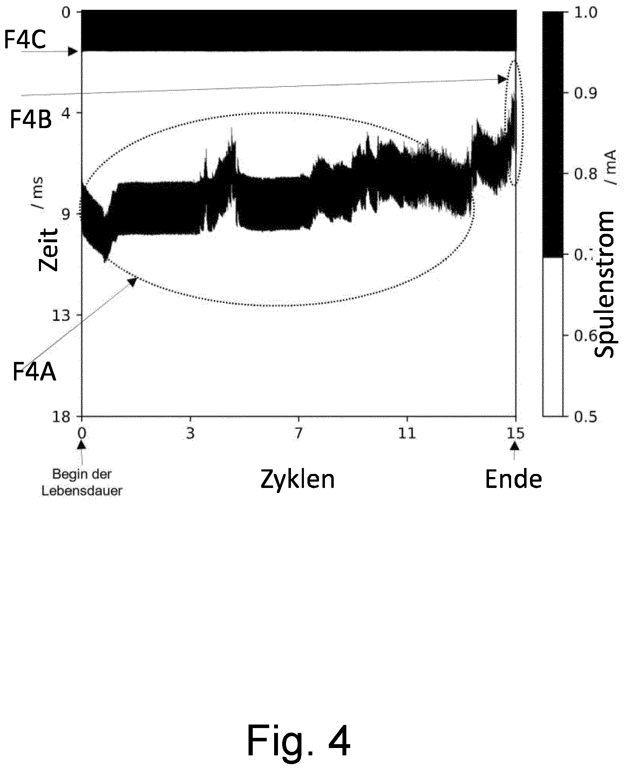

Die Figur 4 zeigt eine schematische Darstellung eines Spulenstroms eines Relais im Ausschaltvorgang exemplarisch über die gesamte Lebensdauer gemäß einem Ausführungsbeispiel der vorliegenden Erfindung.

In Figur 4 ist der Spulenstrom eines Relais im Ausschaltvorgang exemplarisch über die Gesamte Lebensdauer dargestellt. Das Relais wurde unter realistischen Bedingungen in einem vollautomatischen Messaufbau mit einer genormten Last (DC13) gealtert. Es ist stellvertretend für die Relais, die einen spontanen Ausfall aufweisen.

Im Vergleich zu Figur 3 ist zu erkennen, dass der Zeitpunkt, zu dem der Strom induziert wird, zunächst annähernd konstant und nur lokal leichte Abweichungen auszumachen sind. Lediglich kurzfristig vor dem Ausfall des Relais ist eine sprunghafte Änderung des Zeitpunktes zu beobachten. Diese Anomalie in der Form des Stromes ist ein Hinweis auf einen bevorstehenden Ausfall des Relais. Im Kontext dieser Erfindung wäre mit dem Spulenstrom folglich eine Schätzung des Ausfallrisikos eines elektromechanischen Aktors möglich.

Im Bereich F4A in der Figur 4 ist dargestellt, dass ein induzierter Strom ohne Trend vorhanden ist.

Im Bereich F4B in der Figur 4 ist dargestellt, dass eine spontane starke Änderung im Spulenstrom, auch als Anomalie zu bezeichnen, vorhanden ist.

Im Bereich F4C in der Figur 4 ist der Beginn des Ausschaltvorgangs dargestellt.

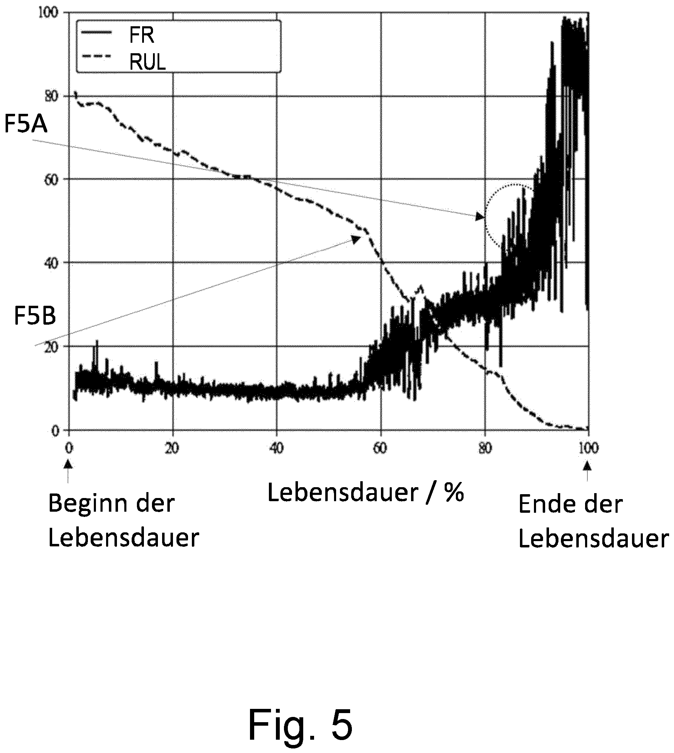

Die Figur 5 zeigt eine schematische Darstellung eines Diagramms, das die Prädiktionen für ein Relais über seine gesamte Lebensdauer gemäß einem Ausführungsbeispiel der vorliegenden Erfindung enthält.

In Figur 5 sind die Prädiktionen für ein Relais über seine gesamte Lebensdauer dargestellt. Es handelt sich um ein Relais, das eine kontinuierliche Degeneration aufweist. Die Prädiktionen sind das Ergebnis eines maschinellen Lernverfahrens, dem die zuvor genannten Zustandsgrößen als Eingabe zugeführt wurden.

Zum einen wird die Restlebensdauer als relativer Anteil der restlichen Schaltzyklen an den gesamten Schaltzyklen geschätzt, mit dieser Größe kann eine langfristige Planung der Instandhaltung durchgeführt werden, da aus den Prädiktionen eine Degenerationsgeschwindigkeit bestimmt werden kann und somit die verbleibende/n Zyklen bzw. Zeit berechnet werden können. Weiterhin wird das Ausfallrisiko geschätzt, dabei werden z.B. kurzfristige anormale Änderungen der Spulenstromform herangezogen.

Diese Zielgröße eignet sich, um kurzfristig Wartungsmaßnahmen einzuleiten, um einen Ausfall des Aktors und damit der Anlage zu verhindern.

Im Bereich F5A in der Figur 5 ist folgendes dargestellt.

Es erfolgt ein Austauschhinweis aufgrund von einem Ausfallrisiko > 50%.

Im Bereich F5B in der Figur 5 ist folgendes dargestellt.

Langfristige Planung der Wartung durch Restlebensdauer (aus den Prädiktionen kann eine Degenerationsgeschwindigkeit berechnet werden, mit der die Zeit oder Zyklen bis zum Ausfall approximiert werden können.

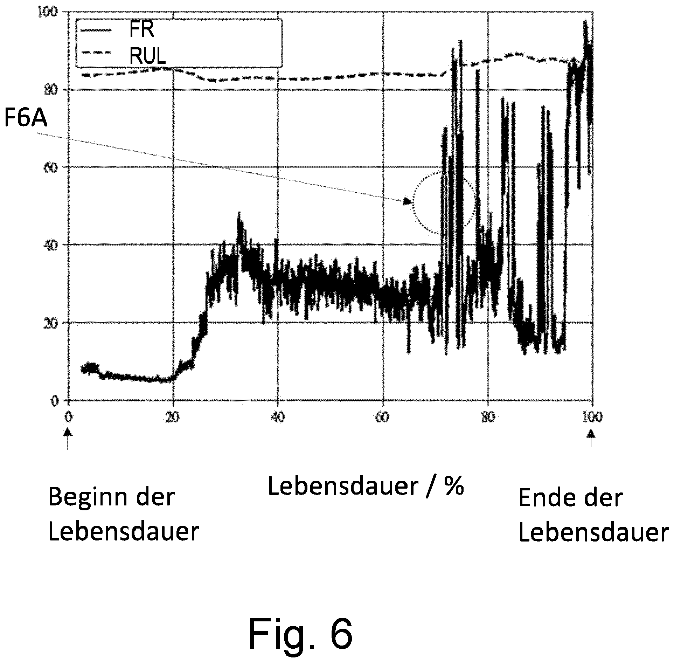

Die Figur 6 zeigt eine schematische Darstellung eines Diagramms, das die Prädiktionen für ein Relais über seine gesamte Lebensdauer gemäß einem Ausführungsbeispiel der vorliegenden Erfindung enthält.

In Figur 6 sind die Prädiktionen für ein Relais über seine gesamte Lebensdauer dargestellt. Es handelt sich um ein Relais, das einen spontanen Ausfall aufweist. Die Prädiktionen sind das Ergebnis desselben maschinellen Lernverfahrens, das für Figur 5 genutzt wurde. Beide Prädiktionen müssen an dieser Stelle differenziert betrachtet werden.

Die Restlebensdauer wird über die gesamte Lebensdauer mit mehr als 80 % geschätzt. Eine langfristige Planung der Instandhaltung auf Basis dieser Prädiktion ist in diesem Fall nicht möglich. Physikalisch kann diese Beobachtung damit begründet werden, dass das Relais nicht aufgrund von langfristiger Degeneration ausgefallen ist, sondern ein kurzfristiger Effekt, wie beispielsweise ein Verkleben der Kontakte zum Ausfall geführt hat.

Ein solcher Effekt kann nicht langfristig erkannt werden und die Prädiktionen der Restlebensdauer sind daher unbrauchbar. An dieser Stelle kann das Ausfallrisiko herangezogen werden, denn vor dem Lebensende des Relais wird diese Zielgröße als besonders hoch eingeschätzt. Eine rechtzeitige Instandhaltung kann auf Basis dieser Größe erfolgen.

Im Bereich F6A in der Figur 6 ist folgendes dargestellt.

Es erfolgt ein Austauschhinweis für die elektromechanische Einrichtung 1000 aufgrund von einem Ausfallrisiko > 50% basierend auf dem aktuellen Betriebszustand der elektromechanischen Einrichtung 1000.

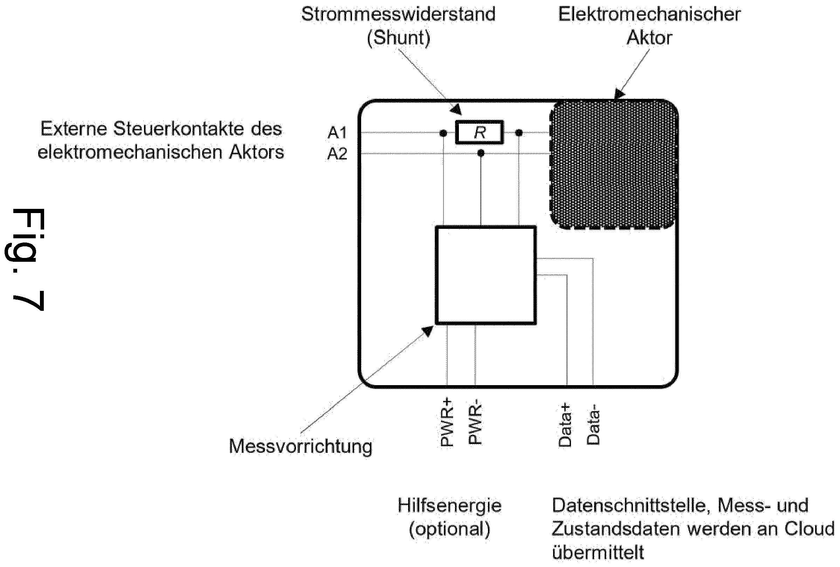

Die Figur 7 zeigt eine schematische Darstellung einer Vorrichtung gemäß einem Ausführungsbeispiel der vorliegenden Erfindung.

In Figur 7 ist ein Minimalbeispiel eines erfindungsgemäßen Aufbaus skizziert. Hier kommt ein Relais- Sockel zum Einsatz, der den Spulenstrom über einen Messwiderstand (Shunt) in eine Spannung umwandelt, welche über eine Messvorrichtung digital erfasst wird und über eine Schnittstelle (Data+ Data-) weiterleitet wird. Es können zusätzliche Daten hinzugefügt werden wie z.B. Zeitstempel, Temperaturen etc. Die Hilfsenergie kann entweder von extern (PWR+ PWR-) hinzugefügt werden oder sie wird aus dem Spulenansteuerungssignal an A1 und A2 abgegriffen.

Wenn dieser Fall gewählt wird, ist darauf zu achten, dass die Energieversorgung nur dann sichergestellt ist, wenn auch eine Spannung an den Anschlüssen A1 und A2 anliegt. Ggf. müsste über einen Pufferkondensator Energie zwischengespeichert werden, um die Daten auch noch nach einem Messvorgang übertragen zu können.

Die Auswertungsvorrichtung wird in diesem Minimalbeispiel extern als Software in einem weiteren Modul oder in der Cloud ausgeführt. Die Eingaben der maschinellen Lernverfahren werden durch die zuvor beschreibende Schnittstelle bezogen.

Optional ist ein Rückkanal, um den Zustand visuell am Relaissockel darzustellen oder Eingriffe in die Steuerung zu ermöglichen.

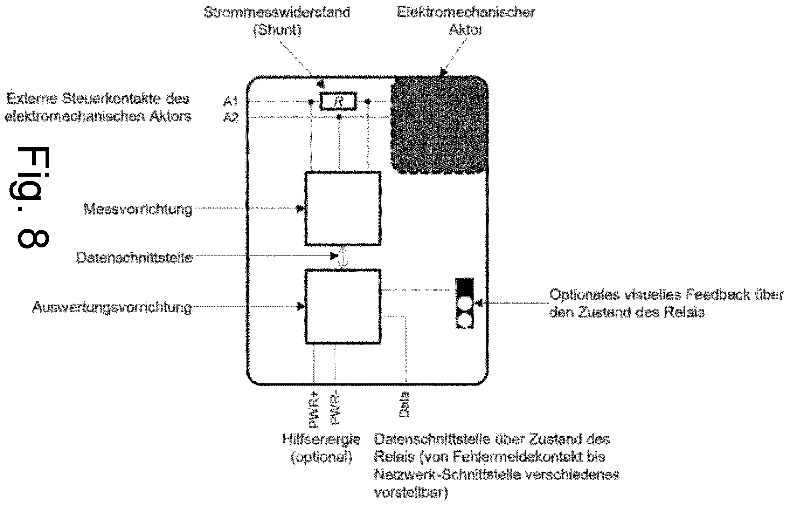

Die Figur 8 zeigt schematische Darstellung eines Stand-Alone-Relais-Sockel gemäß einem Ausführungsbeispiel der vorliegenden Erfindung.

In Figur 8 ist ein Stand-Alone-Relais-Sockel skizziert, der sowohl die Messvorrichtung als auch die Auswertungsvorrichtung beinhaltet. Es gibt eine optionale Anzeige, mit der bspw. die folgenden Fälle visualisiert werden:
. Klasse 1: Neues Produkt
. Klasse 2: Abgenutztes Produkt
. Klasse 3: Ausfallrisiko hoch

Es kann bei dieser Ausführungsform sinnvoll sein, dass das eingesetzte Relais mit dem Relais-Sockel "verheiratet" wird, also z.B. bereits direkt nach der Produktion und vor der Auslieferung des Produktes an den Kunden einige Schaltzyklen durchlaufen werden und das neuronale Netz genau für dieses Relais ein "Finetuning" erhält.

Sollte später ein neues Relais in den Sockel eingesetzt werden, könnte das neuronale Netz z.B. kurzfristig auf das neue Relais nachtrainiert werden. Dies kann in einer sogenannten Initialisierungsphase geschehen.

In einem Ausführungsbeispiel der vorliegenden Erfindung vorgesehen ist ferner vorgesehen, dass Zusatzinformation über das Relais (z.B. Herstellercode) händisch in das Relais-Sockel eingegeben werden, über eine zusätzliche Datenschnittstelle, damit die Prognose des neuronalen Netzes verbessert wird.

Der zusätzliche optionale Datenschnittstelle kann sinnvoll sein, um Informationen über den Zustand des Relais in ein übergeordnetes Netzwerk bereitzustellen. Es ist ebenfalls vorstellbar, dass über die Schnittstelle "Updates" in den Relais-Sockel übertragen werden.

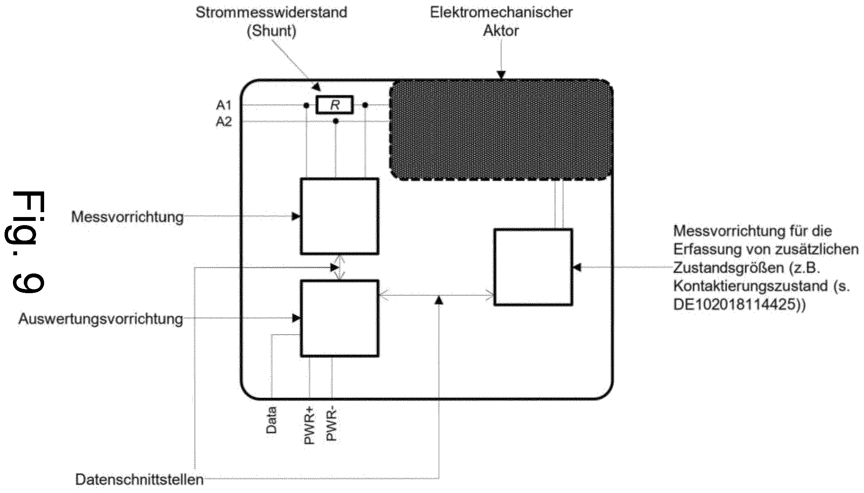

Die Figur 9 zeigt eine schematische Darstellung einer Abwandlung von dem Relais-Sockel aus Figur 8 gemäß einem Ausführungsbeispiel der vorliegenden Erfindung.

In Figur 9 ist eine Abwandlung von dem Relais-Sockel aus Figur 8 derart dargestellt, dass gezeigt wird, dass neben dem Spulenstrom auch noch andere Messtechnik in dem Relais-Sockel integriert sein kann. Die Möglichkeiten sind hier vielfältig und kurz in der Figur 9 beschrieben. Dabei kann vorgesehen sein, dass vorteilhaft entsprechende Schaltungstechnik zum Einsatz kommen kann, um Informationen zum Schaltzeitpunkt des Kontaktes zu erhalten, ohne eine aufwändige direkte Messtechnik auf der Kontaktseite durchführen zu müssen.

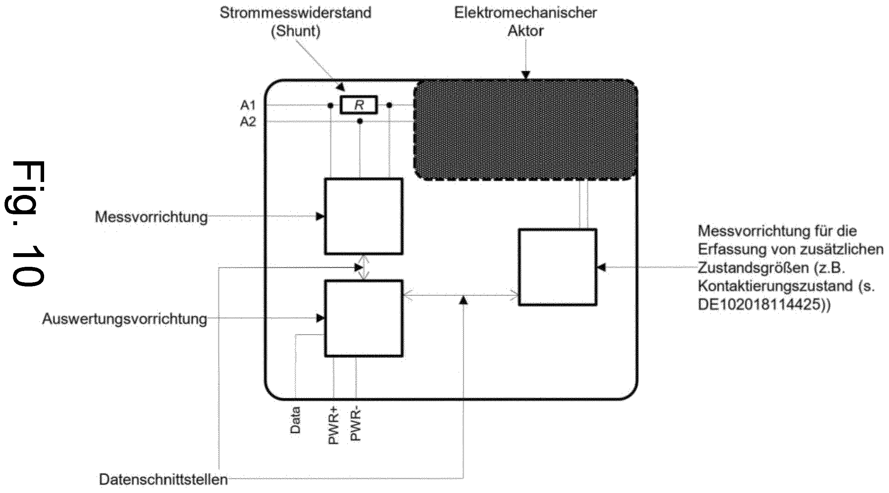

Die Figur 10 zeigt eine schematische Darstellung einer Anordnung, bei der mehrere Relaissockel über einen lokalen Kommunikationsbus miteinander verbunden sind, gemäß einem Ausführungsbeispiel der vorliegenden Erfindung.

In Figur 10 sind mehrere Relaissockel über einen lokalen Kommunikationsbus miteinander verbunden und die einzelnen Messdaten der Relais-Sockel werden von einem zentralen Kopfmodul verwaltet. In dem Kopfmodul kann die Auswertungsvorrichtung eingebracht werden, sodass mehrere elektromechanische Aktoren eine Auswertungsvorrichtung teilen. Dieses Vorgehen ist besonders Kosteneffizient. Das Kopfmodul kann mit einer weiteren Datenschnittstelle ausgestattet sein, um Daten extern zu kommunizieren.

Weiterhin ist es in einem Ausführungsbeispiel der vorliegenden Erfindung vorgesehen, dass vom Kopfmodul die Daten der einzelnen Relais nur gesammelt und/oder vorverarbeitet werden und ein Teil der Auswertungsvorrichtung als Software extern ausgeführt wird.

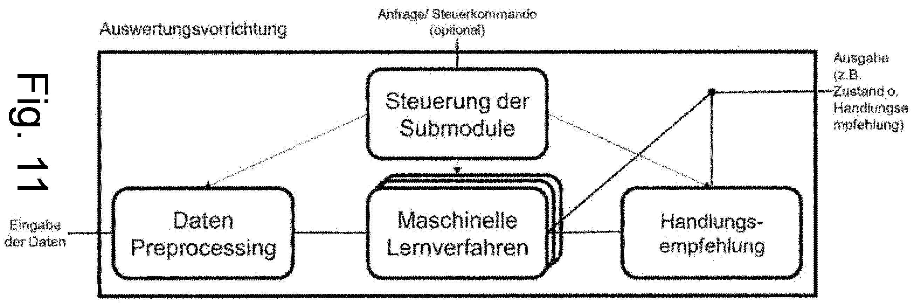

Die Figur 11 zeigt die Funktionsweise der Auswertungsvorrichtung gemäß einem Ausführungsbeispiel der vorliegenden Erfindung.

In Figur 11 wird die Funktionsweise der Auswertungsvorrichtung dargestellt. Es handelt sich um drei Subsysteme, die alle als reine Software ausführbar sind und somit auf beliebigen Endgeräten ausgeführt werden können, vom Mikroprozessor über die Server einer Cloud bis zu lokalen Computern sind diverse Systeme für die Ausführung in unterschiedlichen Ausführungsbeispielen der vorliegenden Erfindung vorgesehen.

Der Auswertungseinrichtung werden Daten eingespeist, wie bspw. Zeitreihen von Spulenstrom und -spannung und dazugehörige Metadaten. Diese Daten müssen zunächst in einem dazu eingerichteten Modul, etwa einem Daten-Vorverarbeitungsmodul, vorverarbeitet werden, so dass die Daten standardisiert werden oder Ausreißer eliminiert werden.

Anschließend werden maschinellen Lernverfahren verwendet, um die oben genannten Ausgaben zu prädizieren. Dargestellt wird dieser Schritt mit mehreren angereihten Modulen, da für die Ausgaben unterschiedliche maschinelle Lernverfahren notwendig sein können.

Die Prädiktionen werden schlussendlich im Modul Handlungsempfehlung genutzt, um konkrete Handlungsempfehlungen, wie beispielsweise 'Aktor wechseln' zu tätigen.

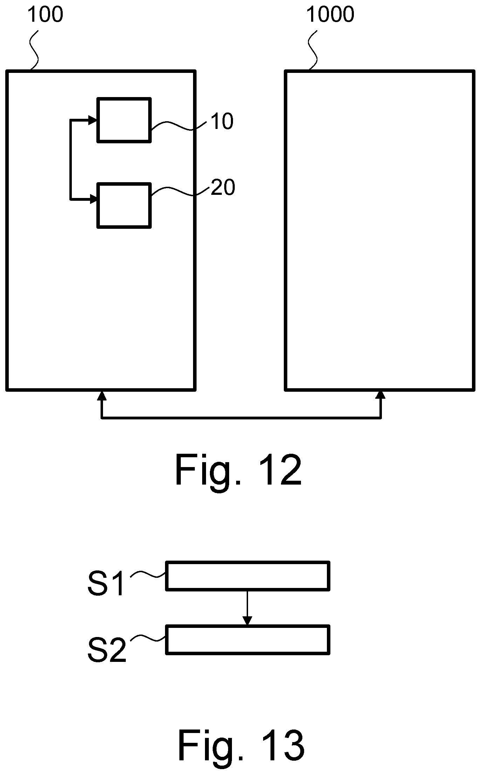

Die Fig. 12 zeigt eine schematische Darstellung einer Vorrichtung 100 zum Erkennen einer Abnutzung einer elektromechanischen Einrichtung 1000 gemäß einem Ausführungsbeispiel der vorliegenden Erfindung.

Die Vorrichtung 100 umfasst eine Messeinrichtung 10 und eine Auswerteeinrichtung 20.

Die Messeinrichtung 10 ist dazu ausgebildet, mindestens einen vorbestimmten Betriebsparameter der elektromechanischen Einrichtung 1000 zu erfassen.

Die Auswerteeinrichtung 20 ist dazu ausgebildet, anhand von maschinellen Lernen unter Zuhilfenahme von Massendaten, vorzugsweise in Form von Trainingsdaten, aus dem erfassten vorbestimmten Betriebsparameter der elektromechanischen Einrichtung einen aktuellen Betriebszustand der elektromechanischen Einrichtung zu ermitteln.

Das vorliegende Verfahren ermöglicht eine Verschleißerkennung, d.h. eine Überwachung einer Abnutzung bzw. des Abnutzungsverhaltens einer elektromechanischen Einrichtung oder eines elektromechanischen Schaltgerätes, bereitzustellen.

Die Messeinrichtung 10 ist beispielsweise als eine Messvorrichtung zum Detektieren eines Betriebsparameters ausgebildet, wie etwa ein Ereignis, d.h. etwa ein Schaltvorgang der elektromechanischen Einrichtung, eine Temperaturerhöhung der elektromechanischen Einrichtung, oder auch eine Entfernung oder ein Ausfall der elektromechanischen Einrichtung in Form des Relais.

Die Messeinrichtung 10 ist beispielsweise als eine Messvorrichtung zur Detektion eines Kurvenverlaufes und/oder einer oder mehrerer charakteristischer Größen des Ereignisses ausgebildet.

Die Auswerteeinrichtung 20 ist beispielsweise dazu ausgebildet, ein Zuordnen von digitalen repräsentativen Daten zu dem aktuellen Ereignis bzw. dem aktuellen Betriebsparameter vorzunehmen.

Es kann ferner ein Einspielen der repräsentativen Daten und/oder der Trainingsdaten und/oder von Zustandsdaten in das künstliche neuronale Netz erfolgen.

Das Ereignis bzw. der Betriebsparameter kann beispielsweise ein Spulenstrom im Einschaltmoment sein, es können auch mehrere elektrische oder physikalische Größen zu einem Betriebsparameter zusammengefasst werden, etwa Spulenstrom und Kontaktspannung. Als Betriebsparameter kann auch ein berechneter Wert wie beispielsweise ein ermittelter Überhub sein.

Die Fig. 13 zeigt eine schematische Darstellung eines Flussdiagramms eines Verfahrens zum Erkennen einer Abnutzung einer elektromechanischen Einrichtung gemäß einem Ausführungsbeispiel der vorliegenden Erfindung.

Als ein erster Verfahrensschritt erfolgt ein Erfassen S1 von mindestens einem vorbestimmten Betriebsparameter der elektromechanischen Einrichtung 1000 mittels einer Messeinrichtung 10.

Als ein zweiter Verfahrensschritt erfolgt ein Ermitteln S2 eines aktuellen Betriebszustandes der elektromechanischen Einrichtung 1000 anhand eines maschinellen Lernen unter Zuhilfenahme von Massendaten, vorzugsweise in Form von Trainingsdaten, aus dem erfassten vorbestimmten Betriebsparameter der elektromechanischen Schalteinrichtung 1000 mittels einer Auswerteeinrichtung.

Weiterhin ist es denkbar eine Steuerungsebene zu nutzen, damit soll es ermöglicht werden, dass automatisch von einer Steuerung oder manuell von einem Nutzer bedarfsgerecht Informationen bezogen werden können. Denkbar wären auf diesem Weg spezielle Abfragen, wie eine Abschätzung der Belastung oder die Überlebenswahrscheinlichkeit in der nächsten Woche.

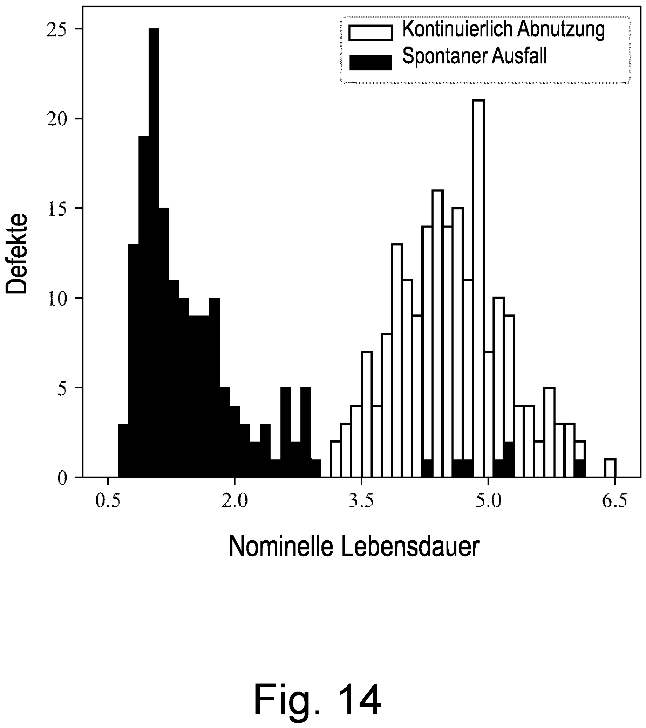

Die Fig. 14 zeigt eine schematische Darstellung einer Fehlerverteilung oder Ausfallverteilung für eine Abnutzung einer elektromechanischen Einrichtung gemäß einem Ausführungsbeispiel der vorliegenden Erfindung.

Aufgrund der in Fig. 14 dargestellten multimodalen Fehlerverteilung bzw. Ausfallverteilung der elektromechanischen Einrichtung kann der Schätzer gemäß einem Ausführungsbeispiel der vorliegenden Erfindung im Betrieb konfiguriert werden, so dass die folgenden zwei Zielwerte gewählt werden:
i. Die Restnutzungsdauer, RUL
ii. Das Ausfallrisiko, FR

Die RUL der elektromechanischen Einrichtung 1000 ist ein typischer Zielwert im Kontext der vorausschauenden Instandhaltung. Messdaten des Betriebs der elektromechanischen Einrichtung 1000 werden als Eingabe verwendet und die Restnutzungsdauer, RUL, und das Ausfallrisiko, FR, der elektromechanischen Einrichtung 1000 werden als Ausgabe vorhergesagt.

Bei der in Fig. 14 dargestellten multimodalen Fehlerverteilung bzw. Ausfallverteilung werden eine kontinuierliche Degeneration der elektromechanischen Einrichtung 1000 und ein spontanes Versagen der elektromechanischen Einrichtung 1000 gemäß einem Ausführungsbeispiel der vorliegenden Erfindung dargestellt.

Die dargestellte Ausfallverteilung wird oft als Badewannenkurve bezeichnet und charakterisiert die multimodale Fehler- bzw. Ausfallverteilung, so dass die Auswerteeinrichtung 20 dazu ausgebildet ist, den aktuellen Betriebszustand aus dem erfassten vorbestimmten Betriebsparameter über eine Mehrzahl von Zielgrößen zu ermitteln, wobei vorzugsweise die Mehrzahl von Zielgrößen einer multimodalen Ausfallverteilung entsprechen.

Die zugrundeliegenden Daten der in Fig. 14 dargestellten multimodalen Fehlerverteilung können als Trainings- bzw. Massendaten für das Trainingsverfahren zum Trainieren eines Schätzers mit Betriebsdaten zu verschiedenen Abnutzungsgraden für eine Vorrichtung zum Erkennen einer Abnutzung einer elektromechanischen Einrichtung verwendet werden.

Obwohl die vorliegende Erfindung anhand bevorzugter Ausführungsbeispiele vorstehend beschrieben wurde, ist sie nicht darauf beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Ergänzend sei darauf hingewiesen, dass "umfassend" und "aufweisend" keine anderen Elemente oder Schritte ausschließt und "eine" oder "ein" keine Vielzahl ausschließt.

in den Ansprüchen sind nicht als Einschränkung anzusehen.

## Patentansprüche

1. Vorrichtung (100) zum Erkennen einer Abnutzung einer elektromechanischen Einrichtung (1000), wobei die Vorrichtung (100) umfasst:
eine Messeinrichtung (10), welche dazu ausgebildet ist, mindestens einen vorbestimmten Betriebsparameter der elektromechanischen Einrichtung (1000) zu erfassen; und
eine Auswerteeinrichtung (20), welche dazu ausgebildet ist, anhand von maschinellen Lernen unter Zuhilfenahme von Massendaten, vorzugsweise in Form von Trainingsdaten, aus dem erfassten vorbestimmten Betriebsparameter der elektromechanischen Einrichtung (1000) einen aktuellen Betriebszustand der elektromechanischen Einrichtung (1000) zu ermitteln;
**dadurch gekennzeichnet, dass** die Auswerteeinrichtung (20) dazu ausgebildet ist, den aktuellen Betriebszustand aus dem erfassten vorbestimmten Betriebsparameter unter Annahme einer multimodalen Ausfallverteilung zu ermitteln.

2. Vorrichtung (100) nach Patentanspruch 1,
wobei die Auswerteeinrichtung (20) dazu ausgebildet ist, für das maschinelle Lernen einen trainierten Schätzer mit Betriebsdaten zu verschiedenen Abnutzungsgraden einzusetzen und den trainierten Schätzer für das Ermitteln des aktuellen Betriebszustands der elektromechanischen Einrichtung (1000) zu verwenden.

3. Vorrichtung (100) nach Patentanspruch 2,
wobei der Schätzer als ein Klassifizierungs- und/oder Regressionsschätzer ausgebildet ist.

4. Vorrichtung (100) nach Patentanspruch 2 oder 3,
wobei der Schätzer ein tiefes, neuronales Netz aufweist, das Faltungsschichten und/oder rekurrente Schichten aufweist.

5. Vorrichtung (100) nach einem der vorhergehenden Patentansprüche,
wobei die Auswerteeinrichtung (20) dazu ausgebildet ist, den aktuellen Betriebszustand aus dem erfassten vorbestimmten Betriebsparameter über eine Mehrzahl von Zielgrößen zu ermitteln, wobei besonders bevorzugt die Mehrzahl von Zielgrößen einer multimodalen Ausfallverteilung entsprechen.

6. Vorrichtung (100) nach einem der vorhergehenden Patentansprüche,
wobei die Messeinrichtung (10) ferner dazu ausgebildet ist, zum dem erfassten mindestens einen vorbestimmten Betriebsparameter der elektromechanischen Einrichtung weitere Informationen in der Form eines Zeitstempels oder eines Zählerstands hinzuzufügen
wobei vorzugsweise die Messeinrichtung (10) ferner dazu ausgebildet ist, den Betriebsparameter der elektromechanischen Einrichtung kontinuierlich zu erfassen oder nur bei einem Schaltereignis der elektromechanischen Einrichtung den Betriebsparameter zu erfassen.

7. Vorrichtung (100) nach einem der vorhergehenden Patentansprüche,
wobei die Auswerteeinrichtung (20) dazu ausgebildet ist, ferner Prädiktionen über einen zukünftigen Betriebszustand der elektromechanischen Einrichtung (1000) zu ermitteln.

8. Vorrichtung (100) nach einem der vorhergehenden Patentansprüche,
wobei die Auswerteeinrichtung (20) dazu ausgebildet ist, den aktuellen Betriebszustand oder die Prädiktionen über den zukünftigen Betriebszustand der elektromechanischen Einrichtung (1000) nach Ablauf einer Zeitspanne oder durch ein Trigger-Ereignis getriggert zu ermitteln.

9. Vorrichtung (100) nach Patentanspruch 7 oder 8,
wobei als Prädiktionen vorgesehen sind:
. eine restliche nutzbare Lebensdauer als relativer Anteil an der gesamten Lebensdauer der elektromechanischen Einrichtung (1000);
. eine restliche nutzbare Lebensdauer als absoluter Anteil an Nutzungszyklen oder -zeit der elektromechanischen Einrichtung (1000);
. eine Risikowahrscheinlichkeit für einen spontanen Ausfall der elektromechanischen Einrichtung (1000);
. eine Typisierung der elektromechanischen Einrichtung (1000);
. ein Koeffizient für eine Belastung oder eine Klassifizierung einer Last der elektromechanischen Einrichtung (1000);
. eine binär-codierte Fehlermeldung;
. eine binär-codierte Betriebsbereitschaft; und/oder
. prozessbezogene Informationen der elektromechanischen Einrichtung (1000).

10. Vorrichtung (100) nach einem der vorhergehenden Patentansprüche,
wobei die Auswerteeinrichtung (20) dazu ausgebildet ist, in eine Fassungsvorrichtung für die elektromechanische Einrichtung (1000) integriert zu werden.

11. Vorrichtung (100) nach einem der vorhergehenden Patentansprüche,
wobei die Vorrichtung (100) ferner eine Anzeigeneinrichtung umfasst, welche vorzugsweise dazu ausgebildet ist, den aktuellen Betriebszustand der elektromechanischen Einrichtung (1000) anzuzeigen.

12. Vorrichtung (100) nach einem der vorhergehenden Patentansprüche,
wobei der mindestens eine vorbestimmte Betriebsparameter der elektromechanischen Einrichtung (1000) eine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung umfasst; und/oder
wobei die Massendaten beliebige Betriebsparameter umfassen und die beliebigen Betriebsparametereine Betätigungskraft, eine Gegenkraft, einen Betätigungsweg, einen Überhub, einen Schaltpunkt, einen Lichtimpuls, einen Lichtbogen, ein akustisches Signal, ein Magnetfeld, eine Temperatur, einen Spulenstrom, eine Spulenspannung, einen Kontaktstrom, einen Laststrom oder eine Kontaktspannung der elektromechanischen Einrichtung (1000) umfassen.

13. Vorrichtung (100) nach einem der vorhergehenden Patentansprüche,
wobei die Messeinrichtung (10) dazu ausgebildet ist, die beliebigen Betriebsparameter als Kennlinien basierend auf einer Vorabmessung während einer Initialisierungsphase der elektromechanischen Einrichtung (1000) zu erfassen.

14. Verfahren zum Erkennen einer Abnutzung einer elektromechanischen Einrichtung (1000), wobei das Verfahren folgende Verfahrensschritte umfasst:
Erfassen (S1) von mindestens einem vorbestimmten Betriebsparameter der elektromechanischen Einrichtung (1000) mittels einer Messeinrichtung (10); und
Ermitteln (S2) eines aktuellen Betriebszustandes der elektromechanischen Einrichtung (1000) anhand eines maschinellen Lernen unter Zuhilfenahme von Massendaten, vorzugsweise in Form von Trainingsdaten, aus dem erfassten vorbestimmten Betriebsparameter der elektromechanischen Schalteinrichtung (1000) mittels einer Auswerteeinrichtung (20);
**dadurch gekennzeichnet, dass** der aktuelle Betriebszustand aus dem erfassten vorbestimmten Betriebsparameter unter Annahme einer multimodalen Ausfallverteilung ermittelt wird.

15. Trainingsverfahren zum Trainieren eines Schätzers mit Betriebsdaten zu verschiedenen Abnutzungsgraden für eine Vorrichtung zum Erkennen einer Abnutzung einer elektromechanischen Einrichtung nach einem der vorhergehenden Patentansprüche 1 bis 13.

## Claims

1. A device (100) for detecting wear of an electromechanical device (1000), the device (100) comprising
a measuring device (10) which is designed to detect at least one predetermined operating parameter of the electromechanical device (1000); and
an evaluation device (20) which is designed to determine a current operating state of the electromechanical device (1000) from the recorded predetermined operating parameter of the electromechanical device (1000) by means of machine learning with the aid of mass data, preferably in the form of training data;
**characterised in that** the evaluation device (20) is designed to determine the current operating state from the recorded predetermined operating parameter assuming a multimodal failure distribution.

2. The device (100) according to claim 1,
wherein the evaluation device (20) is designed to use a trained estimator with operating data for various degrees of wear for machine learning and to use the trained estimator to determine the current operating state of the electromechanical device (1000).

3. The device (100) according to claim 2,
wherein the estimator is designed as a classification and/or regression estimator.

4. The device (100) according to claim 2 or 3,
wherein the estimator comprises a deep neural network comprising convolutional layers and/or recurrent layers.

5. The device (100) according to any one of the preceding claims,
wherein the evaluation device (20) is designed to determine the current operating state from the detected predetermined operating parameter via a plurality of target variables, wherein the plurality of target variables particularly preferably correspond to a multimodal failure distribution.

6. The device (100) according to any one of the preceding claims,
wherein the measuring device (10) is further designed to add further information in the form of a time stamp or a counter reading to the detected at least one predetermined operating parameter of the electromechanical device,
wherein preferably the measuring device (10) is further designed to continuously detect the operating parameter of the electromechanical device or to detect the operating parameter only in the event of a switching event of the electromechanical device.

7. The device (100) according to any one of the preceding claims,
wherein the evaluation device (20) is designed to further determine predictions about a future operating state of the electromechanical device (1000).

8. The device (100) according to any one of the preceding claims,
wherein the evaluation device (20) is designed to determine the current operating state or the predictions about the future operating state of the electromechanical device (1000) after a period of time has elapsed or triggered by a trigger event.

9. The device (100) according to claim 7 or 8,
wherein as predictions are provided:
• a remaining usable lifetime as a relative proportion of the total lifetime of the electromechanical device (1000);
• a remaining usable service life as an absolute proportion of utilisation cycles or utilisation time of the electromechanical device (1000);
• a risk probability for a spontaneous failure of the electromechanical device (1000);
• a typification of the electromechanical device (1000);
• a coefficient for a load or a classification of a load of the electromechanical device (1000);
• a binary-coded error message;
• a binary-coded operational readiness; and/or
• process-related information of the electromechanical device (1000).

10. The device (100) according to any one of the preceding claims,
wherein the evaluation device (20) is designed to be integrated into a mounting device for the electromechanical device (1000).

11. The device (100) according to any one of the preceding claims,
wherein the device (100) further comprises a display device which is preferably designed to display the current operating state of the electromechanical device (1000).

12. The device (100) according to any one of the preceding claims,
wherein the at least one predetermined operating parameter of the electromechanical device (1000) comprises an actuating force, a counterforce, an actuating travel, an overtravel, a switching point, a light pulse, an arc, an acoustic signal, a magnetic field, a temperature, a coil current, a coil voltage, a contact current, a load current or a contact voltage; and/or
wherein the mass data comprises any operating parameters and the any operating parameters comprise an actuating force, a counterforce, an actuating travel, an overtravel, a switching point, a light pulse, an arc, an acoustic signal, a magnetic field, a temperature, a coil current, a coil voltage, a contact current, a load current or a contact voltage of the electromechanical device (1000).

13. The device (100) according to any one of the preceding claims,
wherein the measuring device (10) is designed to detect the arbitrary operating parameters as characteristic curves based on a preliminary measurement during an initialisation phase of the electromechanical device (1000).

14. A method for detecting wear of an electromechanical device (1000), the method comprising the following method steps:
detecting (S1) at least one predetermined operating parameter of the electromechanical device (1000) by means of a measuring device (10); and
determining (S2) a current operating state of the electromechanical device (1000) by means of machine learning with the aid of mass data, preferably in the form of training data, from the recorded predetermined operating parameter of the electromechanical switching device (1000) by means of an evaluation device (20);
**characterised in that** the current operating state is determined from the recorded predetermined operating parameter assuming a multimodal failure distribution.

15. A training method for training an estimator with operating data on different degrees of wear for a device for detecting wear of an electromechanical device according to any of the preceding claims 1 to 13.

## Revendications

1. Dispositif (100) de détection d'usure d'un dispositif électromécanique (1000), dans lequel le dispositif (100) comprend :
un dispositif de mesure (10) qui est conçu pour acquérir au moins un paramètre de fonctionnement prédéterminé du dispositif électromécanique (1000) ; et
un dispositif d'évaluation (20) qui est conçu pour déterminer un état de fonctionnement actuel du dispositif électromécanique (1000) à partir du paramètre de fonctionnement prédéterminé acquis du dispositif électromécanique (1000), par un apprentissage automatique à l'aide de mégadonnées, de préférence sous forme de données d'apprentissage ;
**caractérisé en ce que** le dispositif d'évaluation (20) est conçu pour déterminer l'état de fonctionnement actuel à partir du paramètre de fonctionnement prédéterminé acquis, en supposant une distribution de défaillances multimodale.

2. Dispositif (100) selon la revendication de brevet 1,
dans lequel le dispositif d'évaluation (20) est conçu pour appliquer, pour l'apprentissage automatique, un estimateur entraîné avec des données de fonctionnement à différents degrés d'usure, et pour utiliser l'estimateur entraîné pour déterminer l'état de fonctionnement actuel du dispositif électromécanique (1000).

3. Dispositif (100) selon la revendication de brevet 2,
dans lequel l'estimateur est conçu comme un estimateur de classification et/ou de régression.

4. Dispositif (100) selon la revendication de brevet 2 ou 3,
dans lequel l'estimateur comprend un réseau neuronal profond comprenant des couches de convolution et/ou des couches récurrentes.

5. Dispositif (100) selon l'une des revendications de brevet précédentes,
dans lequel le dispositif d'évaluation (20) est conçu pour déterminer l'état de fonctionnement actuel à partir du paramètre de fonctionnement prédéterminé acquis par une pluralité de grandeurs cibles, dans lequel la pluralité de grandeurs cibles correspondent, de manière particulièrement préférée, à une distribution de défaillances multimodale.

6. Dispositif (100) selon l'une des revendications de brevet précédentes,
dans lequel le dispositif de mesure (10) est en outre conçu pour ajouter des informations supplémentaires ayant la forme d'un horodatage ou d'un état de compteur au au moins un paramètre de fonctionnement prédéterminé acquis du dispositif électromécanique,
dans lequel le dispositif de mesure (10) est en outre de préférence conçu pour acquérir en continu le paramètre de fonctionnement du dispositif électromécanique ou pour acquérir le paramètre de fonctionnement uniquement en cas d'événement de commutation du dispositif électromécanique.

7. Dispositif (100) selon l'une des revendications de brevet précédentes,
dans lequel le dispositif d'évaluation (20) est conçu pour déterminer en outre des prédictions concernant un état de fonctionnement futur du dispositif électromécanique (1000).

8. Dispositif (100) selon l'une des revendications de brevet précédentes,
dans lequel le dispositif d'évaluation (20) est conçu pour déterminer l'état de fonctionnement actuel ou les prédictions concernant le futur état de fonctionnement du dispositif électromécanique (1000) après l'écoulement d'une période de temps ou déclenchement par un événement déclencheur.

9. Dispositif (100) selon la revendication de brevet 7 ou 8, dans lequel sont prévus en tant que prédictions :
- une durée de vie utile restante en part relative de la durée de vie totale du dispositif électromécanique (1000) ;
- une durée de vie utile restante en part absolue de cycles ou de temps d'utilisation du dispositif électromécanique (1000) ;
- une probabilité de risque de défaillance spontanée du dispositif électromécanique (1000) ;
- un type de dispositif électromécanique (1000) ;
- un coefficient pour une charge ou une classification d'une charge du dispositif électromécanique (1000) ;
- un message d'erreur codé binaire ;
- une disponibilité opérationnelle codée binaire ; et/ou
- des informations associées à un processus du dispositif électromécanique (1000).

10. Dispositif (100) selon l'une des revendications de brevet précédentes,
dans lequel le dispositif d'évaluation (20) est conçu pour être intégré dans un dispositif de châssis pour le dispositif électromécanique (1000).

11. Dispositif (100) selon l'une des revendications de brevet précédentes,
dans lequel le dispositif (100) comprend en outre un dispositif d'affichage qui est de préférence conçu pour afficher l'état de fonctionnement actuel du dispositif électromécanique (1000).

12. Dispositif (100) selon l'une des revendications de brevet précédentes,
dans lequel le au moins un paramètre de fonctionnement prédéterminé du dispositif électromécanique (1000) comprend une force d'actionnement, une force de réaction, une course d'actionnement, une surcourse, un point de commutation, une impulsion lumineuse, un arc électrique, un signal acoustique, un champ magnétique, une température, un courant de bobine, une tension de bobine, un courant de contact, un courant de charge ou une tension de contact ; et/ou
dans lequel les mégadonnées comprennent des paramètres de fonctionnement quelconques et les paramètres de fonctionnement quelconques comprennent une force d'actionnement, une force de réaction, une course d'actionnement, une surcourse, un point de commutation, une impulsion lumineuse, un arc électrique, un signal acoustique, un champ magnétique, une température, un courant de bobine, une tension de bobine, un courant de contact, un courant de charge ou une tension de contact du dispositif électromécanique (1000).

13. Dispositif (100) selon l'une des revendications de brevet précédentes,
dans lequel le dispositif de mesure (10) est conçu pour acquérir les paramètres de fonctionnement quelconques sous forme de courbes caractéristiques sur la base d'une mesure préalable au cours d'une phase d'initialisation du dispositif électromécanique (1000).

14. Procédé de détection d'usure d'un dispositif électromécanique (1000), dans lequel le procédé comprend les étapes de procédé suivantes :
acquérir (S1) au moins un paramètre de fonctionnement prédéterminé du dispositif électromécanique (1000) au moyen d'un dispositif de mesure (10) ; et
déterminer (S2), au moyen d'un dispositif d'évaluation (20), un état de fonctionnement actuel du dispositif électromécanique (1000) par un apprentissage automatique à l'aide de mégadonnées, de préférence sous forme de données d'apprentissage, à partir du paramètre de fonctionnement prédéterminé acquis du dispositif de commutation électromécanique (1000) ;
**caractérisé en ce que** l'état de fonctionnement actuel est déterminé à partir du paramètre de fonctionnement prédéterminé acquis en supposant une distribution de défaillances multimodale.

15. Procédé d'apprentissage pour l'apprentissage d'un estimateur avec des données de fonctionnement à différents degrés d'usure pour un dispositif de détection d'usure d'un dispositif électromécanique selon l'une des revendications de brevet 1 à 13 précédentes.
